# EUROPEAN PATENT APPLICATION

(11) **EP 4 848 333 A1**
(43) Date of publication of application: **02.12.2026**
(21) Application number: 24920312.6
(22) Date of filing: 24.01.2024
(51) Int. Cl.: H01L 21/31

(54) **SUBSTRATE PROCESSING METHOD, METHOD FOR MANUFACTURING SEMICONDUCTOR DEVICE, PROGRAM, SUBSTRATE PROCESSING DEVICE, AND GAS SUPPLY SYSTEM**

(71) Applicant: Kokusai Electric Corporation, Tokyo 100-0004 (JP)
(72) Inventor: BANNAE, Yuki, Toyama-shi, Toyama 939-2393 (JP); KAGA, Yukinao, Toyama-shi, Toyama 939-2393 (JP); KURIBAYASHI, Koei, Toyama-shi, Toyama 939-2393 (JP)
(74) Representative: Verscht, Thomas Kurt Albert
(86) International application number: PCT/JP2024/002090
(87) International publication number: WO 2025/158590

(57) **Abstract**

The purpose of the present invention is to provide a technique with which it is possible to suppress deterioration of either or both of film characteristic uniformity in a substrate surface and film characteristic uniformity between surfaces due to insufficient supply of raw material gas. This method includes: (a) a step for closing a first valve of a first gas pipe, and supplying a raw material gas from an upstream side of the first gas pipe to store the raw material gas in the first gas pipe; and (b) a step for opening the first valve of the first gas pipe, supplying a first inert gas from the upstream side of the first gas pipe, and supplying the raw material gas and the first inert gas to the substrate from the first gas pipe.

## Description

### [Technical Field]

The present disclosure relates to a substrate processing method, a method of manufacturing a semiconductor device, a program, a substrate processing apparatus and a gas supply system.

### [Related Art]

As a part of a manufacturing process of a semiconductor device, a process of forming a metal film on a substrate may be performed (see, for example, Patent Document 1).

### [Related Art Document]

### [Patent document]

Patent Document 1: Japanese Patent Laid-Open No. 2021-120472

### [Disclosure]

### [Technical Problem]

An insufficient supply of a source gas may deteriorate one or both of a uniformity of film characteristics within a surface of the substrate and a uniformity of the film characteristics between substrates (between surfaces of the substrates).

According to the present disclosure, there is provided a technique capable of suppressing a deterioration of one or both of a uniformity of film characteristics within a surface of a substrate and a uniformity of the film characteristics between surfaces of substrates, caused by an insufficient supply of a source gas.

### [Technical Solution]

According to the embodiments of the present disclosure, there is provided a technique that includes: (a) storing a source gas in a first gas pipe by closing a first valve of the first gas pipe and supplying the source gas from an upstream side of the first gas pipe; and (b) supplying the source gas and a first inert gas through the first gas pipe to a substrate by opening the first valve of the first gas pipe and supplying the first inert gas from the upstream side of the first gas pipe.

### [Advantageous Effects]

According to some embodiments of the present disclosure, it is possible to suppress a deterioration of one or both of a uniformity of film characteristics within a surface of a substrate and a uniformity of the film characteristics between surfaces of substrates, caused by an insufficient supply of a source gas.

### [Brief Description of Drawings]

FIG. 1 is a diagram schematically illustrating a vertical cross-section of a vertical type process furnace of a substrate processing apparatus according to embodiments of the present disclosure.
FIG. 2 is a block diagram schematically illustrating a configuration of a controller and its related components of the substrate processing apparatus according to the embodiments of the present disclosure.
FIG. 3(A) is a diagram schematically illustrating a flow of exhausting a source gas to an outside of a process chamber, FIG. 3(B) is a diagram schematically illustrating a state where the source gas is stored in a gas supply pipe, and FIG. 3(C) is a diagram schematically illustrating a flow of supplying the source gas to the process chamber.

### [Detailed Description]

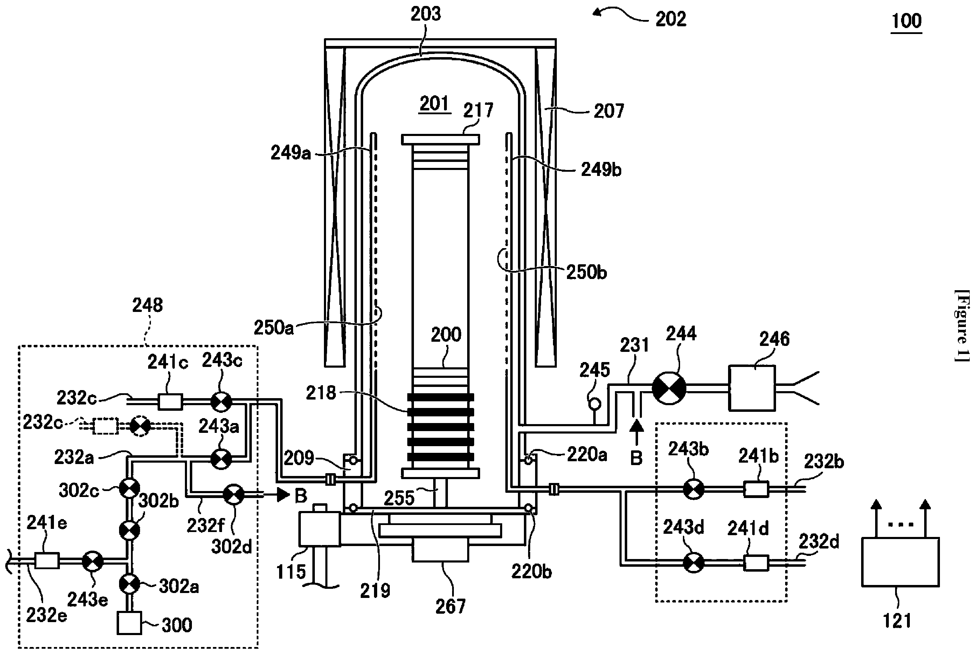

Hereinafter, embodiments of the technique of the present disclosure will be described in detail mainly with reference to FIGS. 1 to 3. In addition, the drawings used in the following descriptions are all schematic. For example, a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

As shown in FIG. 1, a process furnace 202 includes a heater 207 serving as a heating system (which is a temperature adjusting structure). The heater 207 is of a cylindrical shape. The heater 207 also functions as an activator (or an exciter) capable of activating (or exciting) a gas by a heat.

A reaction tube 203 is provided in an inner side of the heater 207 to be aligned in a manner concentric with the heater 207. For example, the reaction tube 203 is made of a heat resistant material such as quartz and silicon carbide. For example, the reaction tube 203 is of a cylindrical shape with a closed upper end and an open lower end. A manifold 209 (hereinafter, also referred to as an "MF 209") is provided under the reaction tube 203 to be aligned in a manner concentric with the reaction tube 203. For example, the MF 209 is made of a metal material such as stainless steel. For example, the MF 209 is of a cylindrical shape with open upper and lower ends. An upper end portion of the MF 209 is engaged with a lower end portion of the reaction tube 203 so as to support the reaction tube 203. An O-ring 220a serving as a seal is provided between the MF 209 and the reaction tube 203. Similar to the heater 207, the reaction tube 203 is installed vertically. A process vessel (also referred to as a "reaction vessel") is constituted mainly by the reaction tube 203 and the MF 209. A process chamber 201 is provided in a hollow cylindrical portion of the process vessel. The process chamber 201 is configured to be capable of accommodating wafers 200.

Nozzles 249a and 249b are provided in the process chamber 201 so as to penetrate a side wall of the MF 209. A gas supply pipe 232a serving as a first gas pipe and a gas supply pipe 232b are connected to the nozzles 249a and 249b, respectively.

A vaporizer 300 capable of vaporizing a gas and opening/closing valves such as a valve 302a serving as a fourth valve, a valve 302b serving as a third valve, a valve 302c serving as a second valve and a valve 243a serving as a first valve are sequentially installed at the gas supply pipe 232a in this order from an upstream side to a downstream side of the gas supply pipe 232a. A gas supply pipe 232e through which an inert gas is supplied is connected to the gas supply pipe 232a at an upstream side of the valve 243a between the valve 302a and the valve 302b. A gas supply pipe 232c through which the inert gas is supplied is connected to the gas supply pipe 232a at a downstream side of the valve 243a. Mass flow controllers (MFCs) 241c and 241e serving as flow rate controllers (flow rate control structures) and valves 243c and 243e are sequentially installed at the gas supply pipes 232c and 232e, respectively, in this order from upstream sides to downstream sides of the gas supply pipes 232c and 232e. An exhaust pipe 232f serving as a third gas pipe through which the gas is exhausted from the gas supply pipe 232a is connected to the gas supply pipe 232a at the upstream side of the valve 243a between the valve 243a and the valve 302c. A valve 302d is installed at the exhaust pipe 232f. The exhaust pipe 232f is connected to an upstream side of an APC valve 244 (which will be described later) of an exhaust pipe 231.

An MFC 241b and a valve 243b are sequentially installed at the gas supply pipe 232b in this order from an upstream side to a downstream side of the gas supply pipe 232b. A gas supply pipe 232d through which the inert gas is supplied is connected to the gas supply pipe 232b at a downstream side of the valve 243b. An MFC 241d and a valve 243d are sequentially installed at the gas supply pipe 232d in this order from an upstream side to a downstream side of the gas supply pipe 232d.

Each of the nozzles 249a and 249b is installed in a space provided between an inner wall of the reaction tube 203 and the wafers 200, and extends upward from a lower portion toward an upper portion of the reaction tube 203 along the inner wall of the reaction tube 203 (that is, extends upward along an arrangement direction of the wafers 200). A plurality of gas supply holes 250a and a plurality of gas supply holes 250b are provided at side surfaces of the nozzles 249a and 249b, respectively. Gases are supplied via the gas supply holes 250a and the gas supply holes 250b, respectively. The gas supply holes 250a and the gas supply holes 250b are open to face a center of the reaction tube 203, and are configured such that the gases are supplied toward the wafers 200 via the gas supply holes 250a and the gas supply holes 250b, respectively. The gas supply holes 250a and the gas supply holes 250b are provided from the lower portion toward the upper portion of the reaction tube 203.

A source gas is supplied into the process chamber 201 from the gas supply pipe 232a through the vaporizer 300, the valves 302a to 302c and 243a and the nozzle 249a. Further, the source gas is exhausted to the exhaust pipe 231 from the gas supply pipe 232a without being supplied into the process chamber 201 through the vaporizer 300, the valves 302a to 302c, the exhaust pipe 232f and the valve 302d. In addition, the source gas is stored in the gas supply pipe 232a by switching the valves 302a to 302d, 243a and 243e.

A reactive gas reacting with the source gas is supplied into the process chamber 201 from the gas supply pipe 232b through the MFC 241b, the valve 243b and the nozzle 249b.

The inert gas is supplied into the process chamber 201 from each of the gas supply pipes 232c and 232d through the MFCs 241c and 241d, the valves 243c and 243d, the gas supply pipe 232a, the gas supply pipe 232b, the nozzle 249a and the nozzle 249b. In addition, the inert gas is supplied into the process chamber 201 from the gas supply pipe 232e through the MFC 241e, the valve 243e, the gas supply pipe 232a and the nozzle 249a.

A source gas supply system is constituted mainly by the gas supply pipe 232a and the valves 302a to 302c and 243a. The source gas supply system may further include the vaporizer 300. A source gas exhaust system is constituted mainly by the exhaust pipe 232f and the valve 302d. The source gas supply system may further include the source gas exhaust system. A reactive gas supply system is constituted mainly by the gas supply pipe 232b, the MFC 241b and the valve 243b. The source gas supply system and the reactive gas supply system may also be collectively referred to as a "gas supply system". In addition, an inert gas supply system is constituted mainly by the gas supply pipes 232c to 232e, the MFCs 241c to 241e and the valves 243c to 243e. Further, the inert gas supplied from the gas supply pipe 232e through the MFC 241e and the valve 243e may also be referred to as a "first inert gas". In such a case, the gas supply pipe 232e, the MFC 241e and the valve 243e may be referred to as a "first inert gas supply system" (also referred to as a "first inert gas supplier"). Further, the inert gas supplied from the gas supply pipe 232c through the MFC 241c and the valve 243c may also be referred to as a "second inert gas". In such a case, the gas supply pipe 232c, the MFC 241c and the valve 243c may be referred to as a "second inert gas supply system" (also referred to as a "second inert gas supplier"). The gas supply system may further include the inert gas supply system.

Any one or an entirety of the supply systems described above may be configured as an integrated gas supply system 248 in which components such as the valves 243a to 243e and 302a to 302d and the MFCs 241a to 241e are integrated. The integrated gas supply system 248 is connected to each of the gas supply pipes 232a to 232e. Operations of the integrated gas supply system 248 to supply various gases to the gas supply pipes 232a to 232e, for example, operations such as opening and closing operations of the valves 243a to 243e and 302a to 302d and flow rate adjusting operations for the gases by the MFCs 241a to 241e may be controlled by a controller 121 described later. The integrated gas supply system 248 may be embodied as an integrated structure (integrated unit) of an all-in-one type or a divided type. The integrated gas supply system 248 may be attached to or detached from components such as the gas supply pipes 232a to 232e on a basis of the integrated structure. Operations such as maintenance, replacement and addition for the integrated gas supply system 248 may be performed on a basis of the integrated structure.

The exhaust pipe 231 through which an atmosphere (inner atmosphere) of the process chamber 201 is exhausted is connected to the reaction tube 203. A vacuum pump 246 (hereinafter, also referred to as a "pump 246") serving as a vacuum exhaust apparatus is connected to the exhaust pipe 231 through a pressure sensor 245 and the APC (Automatic Pressure Controller) valve 244. The pressure sensor 245 serves as a pressure detector (pressure detection structure) configured to detect a pressure (inner pressure) of the process chamber 201, and the APC valve 244 serves as a pressure regulator (pressure adjusting structure). With the pump 246 in operation, the APC valve 244 can be opened or closed to perform a vacuum exhaust operation for the process chamber 201 or stop the vacuum exhaust operation. In addition, with the pump 246 in operation, the inner pressure of the process chamber 201 can be adjusted by adjusting an opening degree of the APC valve 244 based on pressure information detected by the pressure sensor 245. An exhaust system is constituted mainly by the exhaust pipe 231, the APC valve 244 and the pressure sensor 245. The exhauster may further include the pump 246.

A seal cap 219 (hereinafter, also referred to as a "cap 219") serving as a furnace opening lid capable of airtightly sealing (or closing) a lower end opening of the MF 209 is provided below the MF 209. An O-ring 220b serving as a seal is provided on an upper surface of the cap 219 so as to be in contact with the lower end of the MF 209. A rotator (which is a rotating structure) 267 configured to rotate a boat 217 described later is provided under the cap 219. A rotating shaft 255 of the rotator 267 is connected to the boat 217 through the cap 219. The rotator 267 is configured to rotate the wafers 200 by rotating the boat 217. The cap 219 is configured to be elevated or lowered in a vertical direction by a boat elevator 115 (hereinafter, also referred to as an "elevator 115") serving as an elevating structure provided outside the reaction tube 203. The elevator 115 is configured to be capable of transferring (loading) the boat 217 into the process chamber 201 and capable of transferring (unloading) the boat 217 out of the process chamber 201 by elevating and lowering the cap 219. The elevator 115 serves as a transfer apparatus (which is a transfer structure) capable of loading the boat 217 (that is, the wafers 200) into the process chamber 201 and unloading the boat 217 (that is, the wafers 200) out of the process chamber 201.

The boat 217 serving as a substrate support is configured such that the wafers 200 (for example, from 25 wafers to 200 wafers) are accommodated (or supported) in the vertical direction in the boat 217 while the wafers 200 are horizontally oriented with their centers aligned with one another in a multistage manner, that is, such that the wafers 200 are arranged in the vertical direction in the boat 217 while the wafers 200 are horizontally oriented with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner. In addition, in the present specification, a notation of a numerical range such as "from 25 wafers to 200 wafers" means that a lower limit and an upper limit are included in the numerical range. Therefore, for example, a numerical range "from 25 wafers to 200 wafers" means a range equal to or higher than 25 wafers and equal to or less than 200 wafers. The same also applies to other numerical ranges described in the present specification.

A temperature sensor 263 serving as a temperature detector is installed in the reaction tube 203. A state of electric conduction to the heater 207 is adjusted based on temperature information detected by the temperature sensor 263 such that a desired temperature distribution of a temperature (inner temperature) of the process chamber 201 can be obtained.

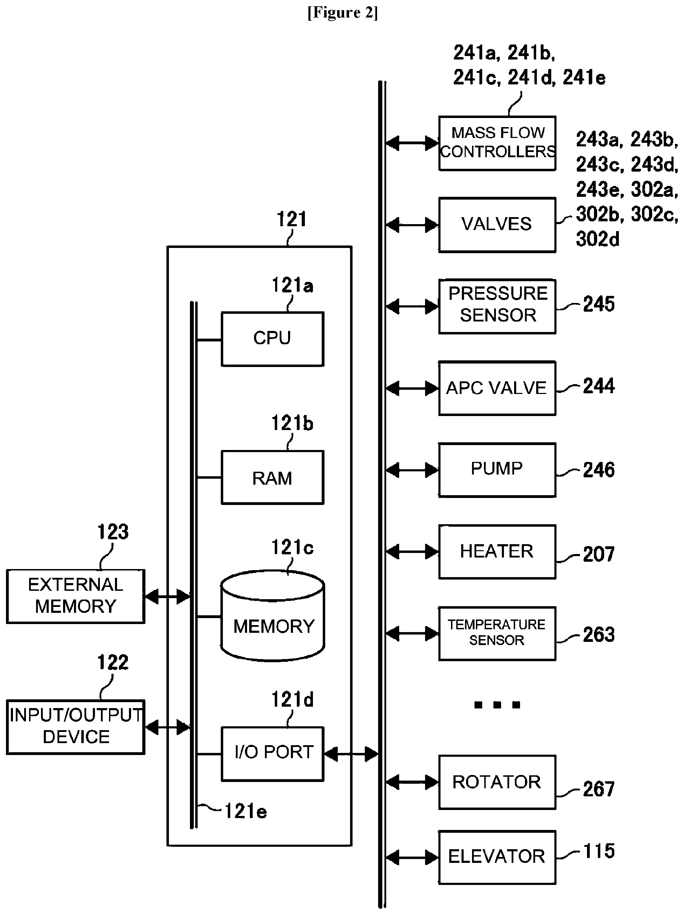

As shown in FIG. 2, the controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the controller 121. For example, as the control structure, the substrate processing apparatus 100 may include a single control structure, or may include a plurality of control structures. That is, a control operation of performing a process sequence described later may be performed using the single control structure, or may be performed using the plurality of control structures. In addition, the plurality of control structures may be configured as a control system that are connected to one another via a wired or wireless communication network, and an entirety of the control system may perform the control operation of performing the process sequence described later. Thus, in the present specification, the term "control structure" may refer to the single control structure, may refer to the plurality of control structures, or may refer to the control system configured by the plurality of control structures. In addition, the control structure may be a physical controller, or may be a software program that exists in a memory of the controller.

For example, the memory 121c is configured by a component such as a flash memory and a hard disk drive (HDD). For example, a control program configured to control an operation of the substrate processing apparatus 100 and a process recipe containing information on procedures and conditions of a substrate processing described later may be readably stored in the memory 121c. The process recipe is obtained by combining steps (procedures) of the substrate processing described later such that the controller 121 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241e, the valves 243a to 243e and 302a to 302d, the pressure sensor 245, the APC valve 244, the pump 246, the heater 207, the temperature sensor 263, the rotator 267 and the elevator 115.

The CPU 121a is configured to read the control program from the memory 121c and execute the control program read from the memory 121c. In addition, the CPU 121a is configured to read the recipe from the memory 121c, for example, in accordance with an operation command inputted from the input/output device 122. In accordance with contents of the recipe read from the memory 121c, the CPU 121a may be configured to control various operations such as the flow rate adjusting operations for various gases by the MFCs 241a to 241e, the opening and closing operations of the valves 243a to 243e and 302a to 302d, an opening and closing operation of the APC valve 244, a pressure regulating operation (pressure adjusting operation) by the APC valve 244 based on the pressure sensor 245, a start and stop operation of the pump 246, a temperature regulating operation (temperature adjusting operation) by the heater 207 based on the temperature sensor 263, an operation of adjusting a rotation and a rotation speed of the boat 217 by the rotator 267 and an elevating and lowering operation of the boat 217 by the elevator 115.

The controller 121 may be embodied by installing the above-described program stored in an external memory 123 into the computer. For example, the external memory 123 may include a magnetic disk such as a hard disk, an optical disk such as a CD, a magneto-optical disk such as an MO and a semiconductor memory such as a USB memory. The memory 121c or the external memory 123 may be embodied by a non-transitory computer readable recording medium storing a program. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. For example, instead of the external memory 123, a communication interface such as the Internet and a dedicated line may be used for providing the program to the computer.

### (2) Substrate Processing

Hereinafter, an example of the process sequence of forming a predetermined film on the wafer 200, which is a part of the substrate processing in a manufacturing process of a semiconductor device performed by using the substrate processing apparatus 100 described above, will be described. In the following description, operations of components constituting the substrate processing apparatus 100 are controlled by the controller 121.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

### <Wafer Loading>

The wafers 200 are charged (transferred) into the boat 217. Then, as shown in FIG. 1, the boat 217 supporting the wafers 200 is elevated by the elevator 115 and thereby loaded (transferred) into the process chamber 201 and accommodated in the process vessel. In such a state, the cap 219 airtightly seals the lower end opening of the MF 209 via the O-ring 220b.

### <Pressure Adjusting and Temperature Adjusting>

Then, the pump 246 vacuum-exhausts (decompresses and exhausts) the inner atmosphere of the process chamber 201 (that is, a space in which the wafers 200 are present (accommodated)) such that the inner pressure of the process chamber 201 reaches and is maintained at a desired pressure (vacuum level). At this time, the inner pressure of the process chamber 201 is measured by the pressure sensor 245, and the APC valve 244 is feedback-controlled based on the pressure information detected by the pressure sensor 245 (pressure adjusting). The pump 246 continuously vacuum-exhausts the inner atmosphere of the process chamber 201 until at least a processing of the wafer 200 is completed. In addition, the heater 207 heats the process chamber 201 such that the inner temperature of the process chamber 201 reaches and is maintained at a desired process temperature. At this time, the state of the electric conduction to the heater 207 is feedback-controlled based on the temperature information detected by the temperature sensor 263 such that a desired temperature distribution of the inner temperature of the process chamber 201 can be obtained (temperature adjusting). The heater 207 continuously heats the process chamber 201 until at least the processing of the wafer 200 is completed.

The source gas used in the present embodiments is a gas with a vapor pressure of, for example, 100 Torr or less (which is lower than vapor pressures of other gases supplied to the wafer 200) and which cannot be supplied by an MFC. When a gas with a low vapor pressure of 100 Torr or less is used as the source gas, a supply amount of the source gas supplied to an upper portion of the nozzle 249a in the process chamber 201 is reduced as compared with a lower portion of the nozzle 249a. As a result, a uniformity of film characteristics between surfaces of the wafers 200 may deteriorate. In addition, since the gas is supplied through an edge of the wafer 200, the supply amount of the source gas supplied to a center of the wafer 200 is reduced as compared with the edge (lateral portion) of the wafer 200. As a result, a uniformity of the film characteristics within the surface of the wafer 200 may deteriorate. Further, when the gas with a low vapor pressure of 100 Torr or less is used as the source gas, the source gas may flow back out of the process chamber 201 without being supplied to the wafers 200. According to the present disclosure, the source gas with a low vapor pressure of, for example, 100 Torr or less is supplied in a source gas supply step described later. In the present specification, for example, the film characteristics may refer to properties such as a thickness, electrical characteristics and composition of the film formed on the wafer 200.

### <Source Gas Supply Step, Step S1>

In the present step, a cycle (wherein the following steps A through D are performed sequentially) is performed a predetermined number of times (m times, wherein m is an integer of 1 or 2 or more).

### <Step A>

In the present step, an atmosphere (inner atmosphere) of the gas supply pipe 232a is exhausted through the exhaust pipe 232f to remove the gas remaining in the gas supply pipe 232a. Specifically, with the valves 302a, 243a and 243e closed, the valves 302b to 302d are opened, and the inner atmosphere of the gas supply pipe 232a is vacuum-exhausted by the APC valve 244 and the pump 246 of the exhaust pipe 231 through the gas supply pipe 232a and the exhaust pipe 232f. At this time, simultaneously, the valve 243c may be opened to supply the inert gas into the gas supply pipe 232c. The inert gas whose flow rate is adjusted by the MFC 241c is supplied into the process chamber 201 through the nozzle 249a, and is exhausted through the exhaust pipe 231. In addition, at this time, the valve 243d may be opened to supply the inert gas into the gas supply pipes 232b and 232d.

By exhausting the inner atmosphere of the gas supply pipe 232a, it is possible to reduce an amount of the gas remaining in the gas supply pipe 232a. In addition, it is possible to prevent the remaining gas from diluting the source gas stored in the step C described later. It is also possible to increase a storage amount of the source gas in the step C. In particular, by exhausting the gas supply pipe 232a to create a vacuum atmosphere, it is possible to improve a storage efficiency for the source gas. It is also possible to keep the storage amount of the source gas or a concentration of the source gas constant for each execution of the cycle.

### <Step B>

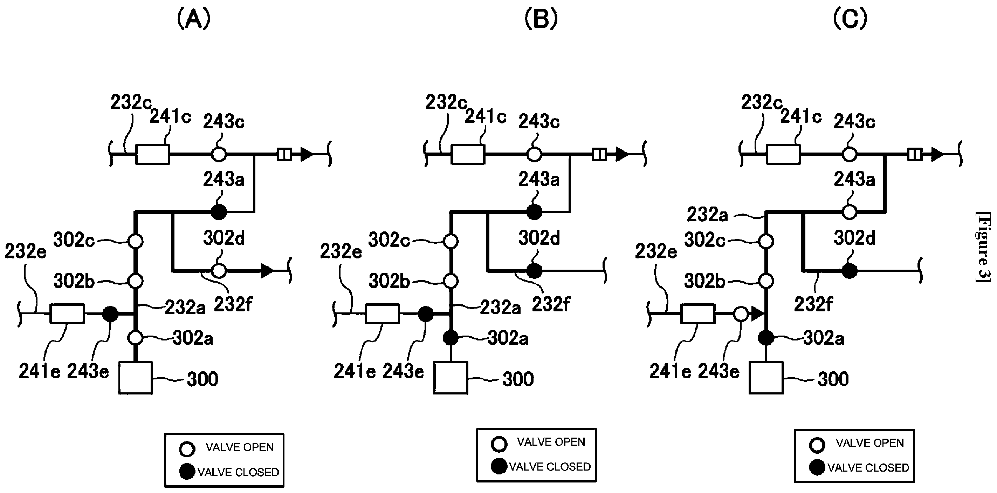

Subsequently, in the present step, as shown in FIG. 3(A), the source gas is supplied from the upstream side of the gas supply pipe 232a to the exhaust pipe 232f. Specifically, with the valves 243a and 243e closed, the valves 302a to 302d are opened, and the source gas is supplied from the upstream side of the gas supply pipe 232a to the exhaust pipe 232f. At this time, simultaneously, the valve 243c is opened to supply the inert gas into the gas supply pipe 232c. Thereby, it is possible to suppress a backflow of the inner atmosphere of the process chamber 201 into the gas supply pipe 232a. The inert gas whose flow rate is adjusted by the MFC 241c is supplied into the process chamber 201 through the nozzle 249a, and is exhausted through the exhaust pipe 231. In addition, at this time, the valve 243d may be opened to supply the inert gas into the gas supply pipes 232b and 232d.

By supplying the source gas from the upstream side of the gas supply pipe 232a to the exhaust pipe 232f, the gas remaining in the gas supply pipe 232a is pushed out by the source gas and exhausted. Thereby, since it is possible to prevent the source gas from being diluted by the gas remaining in the gas supply pipe 232a in a subsequent step, it is possible to prevent a change in the concentration of the source gas in the subsequent step, and it is also possible to keep the concentration of the source gas stored in the subsequent step constant for each execution of the cycle.

### <Step C>

Subsequently, in the present step, as shown in FIG. 3(B), the source gas is stored in the gas supply pipe 232a. Specifically, with the valves 243a and 243e closed, the valves 302a and 302d are closed, and the source gas is stored in the gas supply pipe 232a. At this time, with the valve 243c open, the inert gas is supplied into the gas supply pipe 232c. That is, while the source gas is being stored in the gas supply pipe 232a, the inert gas is supplied from the gas supply pipe 232c through the gas supply pipe 232a to the space in which the wafers 200 are present. Thereby, it is possible to suppress the backflow of the inner atmosphere of the process chamber 201 into the gas supply pipe 232a. The inert gas whose flow rate is adjusted by the MFC 241c is supplied into the process chamber 201 through the nozzle 249a, and is exhausted through the exhaust pipe 231. In addition, at this time, the valve 243d may be opened to supply the inert gas into the gas supply pipes 232b and 232d.

According to the present embodiments, a length of the gas supply pipe 232a between the valve 243a and the valve 302a is configured to be longer than a length of the gas supply pipe 232a between the valve 243a and the reaction tube 203 serving as a process vessel capable of accommodating the wafers 200. Thereby, while increasing the storage amount of the source gas, it is possible to reduce a residual amount (that is, the amount of the gas remaining in the gas supply pipe 232a) when the gas flows back from the process chamber 201 to the gas supply pipe 232a. It is also possible to reduce an amount of the inert gas supplied from the gas supply pipe 232e into the process chamber 201 simultaneously with the source gas.

In the present step, the valve 302c or the valve 302b may be closed instead of the valve 302a, and the source gas may be stored at a downstream side of the valve 302c or a downstream side of the valve 302b. Alternatively, one of the valve 302c and the valve 302b may be closed based on predetermined data, and the source gas may be stored at a downstream side of the valve closed based on the predetermined data. For example, data on the storage amount based on a diameter of the gas supply pipe 232a, a piping length between the valves and the like in a case where each of valves 302a to 302c is closed is stored as the predetermined data in the memory 121c or the like.

In other words, by closing the valve 243a and one of the valve 302a, the valve 302b and the valve 302c, as a storage configured to store a gas such as the source gas, it is possible to use a space of the gas supply pipe 232a between the valve 243a and one of the valve 302a, the valve 302b and the valve 302c. Thereby, while adjusting the storage amount of the source gas stored in the gas supply pipe 232a, it is possible to suppress the backflow from the reaction tube 203.

Specifically, for example, by closing the valve 243a and the valve 302a, it is possible to increase the storage amount in the gas supply pipe 232a as compared with a case where the valve 302b or the valve 302c is closed, and it is also possible to reduce the residual amount when the gas flows back from the process chamber 201 to the gas supply pipe 232a. It is also possible to reduce the amount of the inert gas supplied into the process chamber 201 from the gas supply pipe 232e. In addition, for example, by closing the valve 243a and the valve 302b, it is possible to reduce the storage amount in the gas supply pipe 232a as compared with a case where the valve 302a is closed. In addition, for example, by closing the valve 243a and the valve 302c, it is possible to reduce the storage amount in the gas supply pipe 232a as compared with a case where the valve 302a or the valve 302b is closed.

### <Step D>

Subsequently, in the present step, as shown in FIG. 3(C), the source gas is supplied into the process chamber 201. Specifically, with the valves 302a and 302d closed, the valves 243a and 243e are opened, and the source gas stored in the gas supply pipe 232a is supplied into the process chamber 201. At this time, the source gas stored in the gas supply pipe 232a is pushed out by the inert gas supplied through the gas supply pipe 232e, is supplied into the process chamber 201 through the nozzle 249a, and is exhausted through the exhaust pipe 231. At this time, with the valve 243c open, the flow rate (adjusted by the MFC 241c) of the inert gas supplied to the gas supply pipe 232c is set to be greater than the flow rate of the inert gas supplied to the gas supply pipe 232c in the steps A to C described above. The inert gas whose flow rate is adjusted is supplied into the process chamber 201 together with the source gas, and is exhausted through the exhaust pipe 231. That is, the source gas and the inert gas are supplied through the gas supply pipe 232a to the space in which the wafers 200 are present. In addition, to prevent the source gas from entering the nozzle 249b, the valve 243d is opened to supply the inert gas into the gas supply pipe 232d. The inert gas is supplied into the process chamber 201 through the gas supply pipe 232d and the nozzle 249b, and is exhausted through the exhaust pipe 231.

As described above, after the step C, the valve 243a is opened to supply the inert gas from the upstream side of the gas supply pipe 232a. Thereby, the source gas stored in the gas supply pipe 232a and the inert gas are supplied to the wafer 200. At this time, simultaneously, by setting the flow rate of the inert gas supplied through the gas supply pipe 232c to be greater than the flow rate of the inert gas supplied through the gas supply pipe 232c in the steps A to C described above, the inert gas supplied through the gas supply pipe 232c acts to suppress the backflow of the inner atmosphere of the chamber 201 in the steps A to C and acts to dilute the source gas in the step D. In addition, in the step D, the flow rate of the inert gas supplied through the gas supply pipe 232c is adjusted in accordance with a concentration that the source gas is diluted.

By simultaneously opening the valve 243a and increasing the flow rate of the inert gas supplied through the gas supply pipe 232c, it is possible to keep the concentration of the source gas supplied through the nozzle 249a constant. Alternatively, the valve 243a may be opened after increasing the flow rate of the inert gas supplied through the gas supply pipe 232c. In such a case, it is possible to reduce the concentration of the source gas supplied through the nozzle 249a. Alternatively, the flow rate of the inert gas supplied through the gas supply pipe 232c may be increased after the valve 243a is opened. In such a case, it is possible to increase the concentration of the source gas supplied through the nozzle 249a. That is, in accordance with the concentration at which the source gas is diluted, an opening/closing timing of the valve 243a and the flow rate of the inert gas adjusted by the MFC 241c are controlled.

In addition, in the present step, by adjusting the MFCs 241e and 241c, the flow rate of the inert gas supplied through the gas supply pipe 232e is set to be greater than the flow rate of the inert gas supplied through the gas supply pipe 232c. By supplying the inert gas in such a manner, even when the source gas with a low vapor pressure is used, by pushing out the source gas by the inert gas, it is possible to uniformize the supply amount of the source gas between the wafers 200 and it is possible to uniformize the supply amount of the source gas within the surface of the wafer 200. Thereby, it is possible to suppress a deterioration of one or both of the uniformity of the film characteristics within the surface of the wafer 200 and the uniformity of the film characteristics between the surfaces of the wafers 200, caused by an insufficient supply of the source gas. In particular, it is possible to suppress the deterioration of the uniformity of the film characteristics between the surfaces of the wafers 200.

At this time, a main gas flowing in the process chamber 201 is the source gas. In other words, the source gas is supplied to the wafer 200.

As the source gas, a gas containing a metal element and a halogen element may be used. According to the present embodiments, as the metal element, instead of or in addition to a transition metal from the Group 3 to the Group 12, an element containing a Group 13 element may be used.

As the gas containing the metal element and the halogen element, for example, a gas containing the halogen element and at least one element such as molybdenum (Mo), zirconium (Zr), hafnium (Hf), aluminum (Al), indium (In) and gallium (Ga) may be used. In addition, as the gas containing the metal element and the halogen element, for example, a gas containing the metal element and at least one element such as fluorine (F), chlorine (Cl), bromine (Br) and iodine (I) may be used. As the gas containing the metal element and the halogen element, it is preferable that a gas containing the metal element and chlorine is used. As the source gas, one or more of the gases exemplified above may be used.

That is, as the gas containing the metal element and the halogen element, a gas such as zirconium chloride (ZrCl₄) gas, hafnium chloride (HfCl₄) gas, aluminum chloride (AlCl₃) gas, gallium chloride (GaCl₃) gas, indium chloride (InCl₃) gas, molybdenum pentachloride (MoCl₅) gas, molybdenum dioxide dichloride (MoO₂Cl₂) gas and molybdenum oxide tetrachloride (MoOCl₄) gas may be used. As the source gas, one or more of the gases exemplified above may be used.

As the inert gas, for example, instead of or in addition to nitrogen (N₂) gas, a rare gas such as argon (Ar) gas, helium (He) gas, neon (Ne) gas and xenon (Xe) gas may be used. As the inert gas, it is preferable that the argon gas is used. As the inert gas, one or more of the gases exemplified above may be used.

### <Residual Gas Removing Step, Step S2>

After a first layer containing the metal element and the halogen element is formed on at least a part of the wafer 200, with the valves 243a and 243b closed, the valves 243c and 243d are opened, and the inert gas serving as a purge gas is supplied into the gas supply pipes 232a and 232b through the gas supply pipes 232c and 232d. Simultaneously, with the APC valve 244 of the exhaust pipe 231 open, the process chamber 201 is vacuum-exhausted by the pump 246 to purge the inner atmosphere of the process chamber 201.

### <Reactive gas Supply Step, Step S3>

Subsequently, the reactive gas is supplied to the wafers 200 in the process chamber 201, and then is exhausted. Specifically, the valve 243b is opened, and the reactive gas is supplied into the gas supply pipe 232b. The reactive gas whose flow rate is adjusted by the MFC 241b is supplied into the process chamber 201 through the nozzle 249b, and is exhausted through the exhaust pipe 231. At this time, simultaneously, the valve 243d is opened to supply the inert gas into the gas supply pipe 232d. The inert gas whose flow rate is adjusted by the MFC 241d is supplied into the process chamber 201 together with the reactive gas, and is exhausted through the exhaust pipe 231. In addition, to prevent the reactive gas from entering the nozzle 249a, the valve 243c is opened to supply the inert gas into the gas supply pipe 232c. The inert gas is supplied into the process chamber 201 through the gas supply pipe 232c and the nozzle 249a, and is exhausted through the exhaust pipe 231.

At this time, a main gas flowing in the process chamber 201 is the reactive gas. In other words, the reactive gas is supplied to the wafer 200.

As the reactive gas, a reducing gas may be used. As the reducing gas, for example, a gas containing hydrogen element (H) may be used. As the gas containing hydrogen element, a gas such as hydrogen (H₂) gas, monosilane (SiH₄) gas, disilane (Si₂H₆) gas, trisilane (Si₃H₈) gas, ammonia (NH₃) gas, hydrazine (N₂H₄) gas and phosphine (PH₃) gas may be used. As the reactive gas, one or more of the gases exemplified above may be used.

Specifically, when, for example, the MoCl₅ gas is used as the source gas and, for example, the H₂ gas is used as the reactive gas, the MoCl₅ gas and the H₂ gas react with each other, so that chlorine (Cl) in the MoCl₅ gas is reduced by the H₂ gas. As a result, the first layer containing the metal element and the halogen element formed on the wafer 200 is modified into a second layer containing the metal element.

### <Residual Gas Removing Step, Step S4>

After the second layer containing the metal element is formed on the wafer 200, by process procedures similar to those of the step S2 described above, the inert gas serving as the purge gas is supplied. Simultaneously, with the APC valve 244 of the exhaust pipe 231 open, the process chamber 201 is vacuum-exhausted by the pump 246 to purge the inner atmosphere of the process chamber 201.

### <Performing Predetermined Number of Times, Step S5>

By performing a cycle (wherein the steps S1 to S4 described above are performed sequentially) a predetermined number of times (n times, wherein n is an integer of 1 or 2 or more), it is possible to form a film of a predetermined thickness on the wafer 200. Specifically, for example, a molybdenum-containing film serving as a metal-containing film is formed. When the number of executions of the cycle of performing the steps S1 to S4 sequentially is less than the predetermined number of times, the step S1 is performed again.

### <After-purge and Returning to Atmospheric Pressure>

Then, the inert gas is supplied into the process chamber 201 through each of the gas supply pipes 232c and 232d, and is exhausted through the exhaust pipe 231. The inert gas acts as the purge gas. Thereby, the inner atmosphere of the process chamber 201 is purged with the inert gas. As a result, the gas remaining in the process chamber 201 and reaction by-products remaining in the process chamber 201 are removed from the process chamber 201. Thereafter, the inner atmosphere of the process chamber 201 is replaced with the inert gas, and the inner pressure of the process chamber 201 is returned to the normal pressure (atmospheric pressure).

### <Wafer Unloading>

The cap 219 is lowered by the elevator 115, and the lower end of the MF 209 is opened. The boat 217 with the wafers 200 (which are processed) supported therein is unloaded out of the reaction tube 203 through the lower end of the MF 209. Then, the wafers 200 (which are processed) are discharged out of the boat 217.

### (3) Other Embodiments

Subsequently, modified examples of the substrate processing apparatus 100 in the embodiments mentioned above will be described in detail. In the following description of the modified examples, features different from those of the embodiments mentioned above will be described in detail.

### <Modified Examples>

According to a modified example, as shown by a dashed line in FIG. 1, the gas supply pipe 232c through which the inert gas is supplied is provided at the upstream side of the valve 243a of the gas supply pipe 232a. Even when the gas supply pipe 232c is provided at the upstream side of the valve 243a of the gas supply pipe 232a, it is possible to dilute the source gas before being supplied to the wafers 200, and it is also possible to increase the supply amount of the source gas. That is, according to such a modified example, it is possible to obtain substantially the same effects as in the embodiments mentioned above.

For example, the embodiments mentioned above are described by way of an example in which the cycle (wherein the steps A through D are performed sequentially) is performed a predetermined number of times (m times, wherein m is an integer of 1 or 2 or more) in the source gas supply step (step S1). However, the technique of the present disclosure is not limited thereto. For example, a cycle (wherein the steps B through D are performed sequentially without performing the step A) may be performed a predetermined number of times (m times, wherein m is an integer of 1 or 2 or more). According to such a modified example, it is possible to obtain substantially the same effects as in the embodiments mentioned above, and it is possible to further shorten a process time.

For example, the embodiments mentioned above are described by way of an example in which a batch type substrate processing apparatus capable of simultaneously processing a plurality of wafers is used to form the film. However, the technique of the present disclosure is not limited thereto. For example, the technique of the present disclosure may be preferably applied when a single wafer type substrate processing apparatus capable of processing one or several wafers at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process procedures and the process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

In addition, the embodiments and the modified examples mentioned above may be appropriately combined. The process procedures and the process conditions of each combination thereof may be substantially the same as those of the embodiments mentioned above or the modified examples mentioned above.

While the technique of the present disclosure is described in detail by way of the embodiments and the modified examples mentioned above, the technique of the present disclosure is not limited thereto. The technique of the present disclosure may be modified in various ways without departing from the scope thereof.

### [Description of Reference Numerals]

| | | | |
|---|---|---|---|
| 200: | wafer (substrate) | 232a: | gas supply pipe (first gas pipe) |
| 243a: | valve (first valve) | | |

## Claims

1. A substrate processing method comprising:
(a) a step of storing a source gas in a first gas pipe by closing a first valve of the first gas pipe and supplying the source gas from an upstream side of the first gas pipe; and
(b) a step of supplying the source gas and a first inert gas through the first gas pipe to a substrate by opening the first valve of the first gas pipe and supplying the first inert gas from the upstream side of the first gas pipe.

2. The substrate processing method of claim 1, wherein, in (b), a second inert gas is supplied to the first gas pipe through a second gas pipe connected to the first gas pipe.

3. The substrate processing method of claim 2, wherein the second gas pipe is provided downstream of the first valve.

4. The substrate processing method of claim 2, wherein the second gas pipe is located upstream of the first valve.

5. The substrate processing method of claim 3, further comprising
(c) a step of supplying the second inert gas through the second gas pipe via the first gas pipe to a space in which the substrate is present during (a).

6. The substrate processing method of claim 5, wherein a flow rate of the second inert gas in (b) is set to be greater than a flow rate of the second inert gas in (c).

7. The substrate processing method of claim 2, wherein, in (b), a flow rate of the first inert gas is set to be greater than a flow rate of the second inert gas.

8. The substrate processing method of claim 1, further comprising
(d) a step of supplying the source gas from the upstream side of the first gas pipe to a third gas pipe located upstream of the first valve of the first gas pipe,
wherein (a) is performed after (d).

9. The substrate processing method of claim 1, further comprising
(e) a step of exhausting an inner atmosphere of the first gas pipe through a third gas pipe located upstream of the first valve of the first gas pipe,
wherein (e) is performed before (a).

10. The substrate processing method of claim 8, further comprising
(f) a step of exhausting an inner atmosphere of the first gas pipe through the third gas pipe,
wherein (f) is performed before (d).

11. The substrate processing method of claim 1, wherein, in (a), the source gas is stored in a space downstream of a second valve located upstream of the first valve of the first gas pipe by closing the second valve.

12. The substrate processing method of claim 11, wherein, in (a), the source gas is stored in a space downstream of one of the second valve and a third valve located upstream of the second valve of the first gas pipe by closing the one of the second valve and the third valve based on predetermined data.

13. The substrate processing method of claim 1, wherein a length of the first gas pipe between the first valve and a fourth valve located upstream of the first valve of the first gas pipe is set to be longer than a length of the first gas pipe between the first valve and a process vessel capable of accommodating the substrate.

14. The substrate processing method of claim 1, wherein a vapor pressure of the source gas is set to be lower than vapor pressures of other gases supplied to the substrate.

15. The substrate processing method of claim 1, wherein the source gas contains a halogen element and at least one element among molybdenum, zirconium, hafnium, aluminum, indium and gallium.

16. A method of manufacturing a semiconductor device, comprising
(a) a step of storing a source gas in a first gas pipe by closing a first valve of the first gas pipe and supplying the source gas from an upstream side of the first gas pipe; and
(b) a step of supplying the source gas and a first inert gas through the first gas pipe to a substrate by opening the first valve of the first gas pipe and supplying the first inert gas from the upstream side of the first gas pipe.

17. A program that causes a substrate processing apparatus, by a computer, to perform:
(a) a sequence of storing a source gas in a first gas pipe by closing a first valve of the first gas pipe and supplying the source gas from an upstream side of the first gas pipe; and
(b) a sequence of supplying the source gas and a first inert gas through the first gas pipe to a substrate by opening the first valve of the first gas pipe and supplying the first inert gas from the upstream side of the first gas pipe.

18. A substrate processing apparatus comprising:
a first gas pipe through which a source gas is supplied to a substrate;
a first valve provided at the first gas pipe;
a first inert gas supplier configured to supply a first inert gas from an upstream side of the first gas pipe; and
a controller configured to be capable of controlling the first valve and the first inert gas supplier to perform:
(a) a process of storing the source gas in the first gas pipe by closing the first valve of the first gas pipe and supplying the source gas from the upstream side of the first gas pipe; and
(b) a process of supplying the source gas and the first inert gas through the first gas pipe to the substrate by opening the first valve of the first gas pipe and supplying the first inert gas from the upstream side of the first gas pipe.

19. A gas supply system comprising:
a first gas pipe through which a source gas is supplied to a substrate;
a first valve provided at the first gas pipe; and
a first inert gas supplier configured to supply a first inert gas from an upstream side of the first gas pipe,
wherein the gas supply system is configured to be capable of controlling the first valve and the first inert gas supplier to perform:
(a) a process of storing the source gas in the first gas pipe by closing the first valve of the first gas pipe and supplying the source gas from the upstream side of the first gas pipe; and
(b) a process of supplying the source gas and the first inert gas through the first gas pipe to the substrate by opening the first valve of the first gas pipe and supplying the first inert gas from the upstream side of the first gas pipe.
